# FASCICULE DE BREVET EUROPEEN

(11) **EP 0 376 798 B1**
(45) Date de publication et mention de la délivrance du brevet: **18.08.1993**
(21) Numéro de dépôt: 89403536.9
(22) Date de dépôt: 19.12.1989
(51) Int. Cl.: C30B 23/02, C30B 29/58

(54) **Couche de polydiacétylène orientée**
Orientierte Polydiacetylen-Schicht
Oriented polydiacetylene layer

(30) Priorité: 26.12.1988 FR 8817178
(43) Date de publication de la demande: 04.07.1990
(73) Titulaire: QUARTZ ET SILICE, 92400 Courbevoie (FR)
(72) Inventeur: Le Moigne, Jacques, F-67000 Strasbourg (FR); Thierry, Annette, F-67000 Strasbourg (FR); Guerder, Pierre, Vrigny F-45300 Pithiviers (FR)
(74) Mandataire: de Toytot, Robert

(56) Documents cités:
- US-A- 4 684 434
- PROC. SPIE - INT. SOC. OPT. ENG. 1988, vol. 971 (Nonlinear Opt. Prop. Org. Mater.) 17-19 août 1988, pages 173-177, San Diego, CA, US
- CHEMICAL ABSTRACTS, vol. 109, no. 10, 5 septembre 1988, page 28, résumé no. 74314w, Columbus, Ohio, US; J. LE MOIGNE et al.: "Morphology, linear and nonlinear optical studies of poly[1,6-di(N-carbazolyl)-2,4 hexadiyne] thin films (pDCH)", & J. CHEM. PHYS. 1988, 88(10), 6647-54
- MOL. CHRYST. LIQ. CRYST., vol. 93, 1983, pages 307-314, Gordon and Breach, Science Publishers, Inc., US; S.E. RICKERT et al.: "The formation of single crystal films of polydiacetylenes"
- APPLIED PHYSICS LETTERS, vol. 51, no. 23, 7 décembre 1987, pages 1957-1959, American Institute of Physics, New York, US; T. KANETAKE et al.: "Highly oriented polydiacetylene films by vacuum deposition"

## Description

L'invention concerne un produit comportant une couche de polydiacétylène déposée sur un monocristal, elle concerne également le procédé permettant d'obtenir le produit ainsi que l'application dudit produit dans les techniques d'optique non linéaire.

Il est très intéressant de disposer de couches minces organiques qui bénéficient de propriétés d'optique non-linéaire et qui aient une surface de plusieurs cm². Elle peuvent alors être utilisées dans de nombreuses applications en particulier, celles de la photoréfringence comme le stockage optique de l'information, les fonctions logiques ou les interconnexions dynamiques.

Les polymères de polydiacétylène de formule générale [R-C-C≡C-C-R']ₙ sont connus pour avoir des susceptibilités non-linéaires d'ordre 3 (X⁽³⁾) importantes, les polydiacétylènes monocristallins présentant les valeurs de X⁽³⁾ les plus élevées de ces systèmes.

On a proposé des méthodes de préparation de cristaux de polydiacétylène qui ne permettent pas cependant d'aboutir à des produits très intéressants.

Avec certaines méthodes on peut préparer des monocristaux de polydiacétylène qui sont de bonne qualité mais leurs dimensions restent faibles (nettement inférieure au centimètre carré) et les contraintes qui apparaissent dans le cristal au cours de la polymérisation peuvent induire de nombreux défauts entrainant même, dans certains cas, la destruction du cristal.

La préparation de couches finement polycristallines de diacétylènes permet de contourner ces problèmes liés aux modifications des paramètres géométriques des mailles cristallines au cours de la polymérisation mais cette méthode ne permet généralement de conserver l'ordre cristallin qu'à l'échelle du microcristal. L'arrangement des microcristaux est le plus souvent aléatoire et la valeur macroscopique de la susceptibilité cubique est moyennée sur toutes les orientations possibles.

L'épitaxie constitue une méthode permettant la croissance orientée d'une substance par dépôt sur un substrat monocristallin. Elle a été utilisée pour les polydiacétylènes de différentes manières. On utilise comme supports des monocristaux minéraux tels que KCl ou KBr et on obtient en général des couches polycristallines biorientées dont, par conséquent, les propriétés d'optique non-linéaire sont difficiles à exploiter pratiquement.

On voit ainsi que jusqu'à présent, les méthodes qu'on a proposées permettent soit l'obtention de monocristaux fragiles et de petite taille, soit de couches polycristallines qui, à cause de leur absence d'orientation unique ne permettent pas d'exploiter les performances optiques qu'on attend des polydiacétylènes cristallisés.

L'invention se donne pour tâche de fournir un produit qui concilie ces deux impératifs les fortes susceptibilités non-linéaires des couches mono-orientées et les qualités de grandes surfaces optiques de films microcristallins.

Des couches monocristallines de polydiacétylène ont été obtenues par une méthode décrite dans le brevet US 4 684 434. La méthode comprend deux étapes, tout d'abord la création d'une couche liquide où se trouve le monomère, soit fondu soit en solution, puis l'exercice d'une pression sur la couche liquide maintenue entre deux surfaces de verre, de quartz ou de monocristaux de sels minéraux. Dans une deuxième étape, le monomère se solidifie soit par évaporation lente du solvant soit par refroidissement lent, la polymérisation s'effectuant dans une troisième phase par exposition à un rayonnement ultraviolet. Les monocristaux obtenus ont des surfaces qui peuvent atteindre quelques dixièmes de centimètre carré.

Une autre méthode décrite en 1987 dans Applied Physics Letters 51 (23) p. 1957 permet d'obtenir des couches polycristallines de plusieurs centimètres carrés de surface avec un bon alignement des cristaux les uns par rapport aux autres. La méthode consiste à faire fondre le monomère purifié dans un creuset de quartz, à le chauffer jusqu'à 125°C sous un vide de 8-10⁻⁴ Pascals et à recueillir le condensat sur un substrat de verre maintenu à une température de 10°C. Dans une deuxième étape le film de monomère d'une épaisseur de quelques dizaines de nanomètres est polymérisé à l'air aux ultra-violets ce qui fournit un film isotrope. L'orientation est obtenue dans une troisième étape au cours de laquelle, la couche polycristalline est frottée légèrement de manière unidirectionnelle avec un tissu silicone, on amincit ainsi la couche et on oriente les cristaux résiduels à la surface du verre. La phase suivante consiste en un nouveau dépôt de monomère dans les mêmes conditions que précédemment suivi également d'une polymérisation sous UV. On obtient de la sorte, un film d'une épaisseur de plusieurs centaines de nanomètres dont les polycristaux ont leur face (O1O) parallèle au substrat et leur direction <OO1> alignée avec la direction du frottement mécanique de la troisième étape du procédé. Cependant des fissures perpendiculaires à la direction du frottement sont observées, elles introduisent des discontinuités dans la couche.

Dans une troisième famille de méthodes enfin, l'orientation est obtenue par épitaxie, on provoque le dépôt d'une couche polycristalline sur un monocristal minéral sur lequel les petits cristaux unitaires s'orientent. Une telle méthode est décrite par exemple en 1988 dans Journal of Chemical Physics 88 (10) p. 6647. On fait chauffer dans un creuset sous un vide de 10⁻⁵ Pa des cristaux de monomère de [1,6-di-(n-carbazolyl)-2,4-hexadiyne]. A une certaine distance, au-dessus du creuset on a placé un monocristal fraîchement clivé, de KBr, par exemple, sur lequel le monomère se dépose. On obtient ainsi un film uniforme qui est ensuite porté à une température de 150°C jusqu'à polymérisation complète. Une variante de cette méthode utilise un monocristal organique de 2-5 pipérazine-dione. On obtient de la sorte des films continus d'une épaisseur de 25 nm ou davantage, de grande surface et constitués de polycristaux biorientés. Les taches de diffraction sont dédoublées et l'angle correspondant est au moins de 10°.

On voit que les trois techniques précédentes fournissent, une couche comprenant des monocristaux de petite taille pour la première, une couche polycristalline orientée, mais avec une biorientation pour la troisième. Quant à la seconde méthode elle est très laborieuse et très difficile à mettre en oeuvre industriellement de plus, les contraintes qui subsistent après la phase de frottements mécaniques provoquent des fissures dans la couche finale.

Le produit proposé par l'invention est à la fois uniforme sur une grande surface, mono-orienté et dénué de fissures.

Il s'agit d'un produit comportant une couche de polydiacétylène déposée sur un monocristal, la couche de polydiacétylène étant déposée par épitaxie sur un monocristal organique, comportant des groupements aromatiques, les orthophtalates convenant particulièrement. L'invention concerne particulièrement une couche de polydiacétylène déposée par épitaxie sur un monocristal d'orthophtalate acide d'un métal alcalin ou d'ammonium ou de thallium.

On peut choisir comme diacétylène le [1,6-di-(n-carbazolyl)-2,4-hexadiyne]. Le cristal support est de préférence fraichement clivé et celà selon un plan (001).

La couche de polydiacétylène obtenue est polycristalline, le fond est microcristallin et formé de cristaux de 0,1 à 0,3 µm, il supporte des aiguilles parallèles de 2 à 6 µm de long.

L'invention concerne également le procédé d'élaboration d'un produit comportant une couche de polydiacétylène microcristalline orientée et comportant les étapes suivantes :
a. clivage d'un monocristal d'orthophtalate acide d'un métal alcalin, ou d'ammonium ou de thallium selon un plan (001),
b. dépôt sur la face obtenue, par évaporation thermique sous vide, d'un monomère diacétylénique,
c. polymérisation du dépôt précédent.

L'évaporation thermique est de préférence celle du [1,6-di-(n-carbazolyl)-2,4- hexadiyne] et elle se produit entre 150 et 240°C sous vide inférieur à 10⁻⁴Pa.

La polymérisation du diacétylène s'effectue avantageusement à une température d'autant plus élevée que la durée est plus courte. Cette température est comprise entre 140 et 170°C.

Le clivage de l'orthophtalate s'effectue juste avant le dépôt qui se fait en tous cas avant que la surface vierge ait eu le temps de se dégrader dans son environnement. A l'atmosphère ambiante ce temps est inférieur à 3 minutes.

L'invention concerne de plus l'application de la couche de polydiacétylène déposée par épitaxie sur un monocristal d'orthophtalate acide d'un métal alcalin, ou d'ammonium, ou de thallium à des utilisations en optique non-linéaire.

Les figures et la description qui vont suivre permettront de comprendre l'invention et de constater les avantages qu'elle présente par rapport à l'état de la technique.

La figure 1 représente, sous forme schématique, le dispositif permettant la mise en oeuvre d'un procédé qui conduit au produit polydiacétylène orienté sur monocristal de phtalate acide.

La figure 2 présente le spectre de transmission d'un polydiacétylène déposé sur de la silice amorphe.

La figure 3 présente en revanche les mêmes spectres obtenus sur une couche selon l'invention avec de la lumière polarisée dont les plans de polarisation sont respectivement parallèle et perpendiculaire à l'axe b des cristaux de KAP.

Les figures 4, 5 et 6 quant à elles présentent des images de diffraction électronique obtenues sur différentes couches polycristallines de polydiacétylène déposées par épitaxie respectivement sur KBr, sur phtalate acide de potassium (KAP) et sur phtalate acide de rubidium (RbAP).

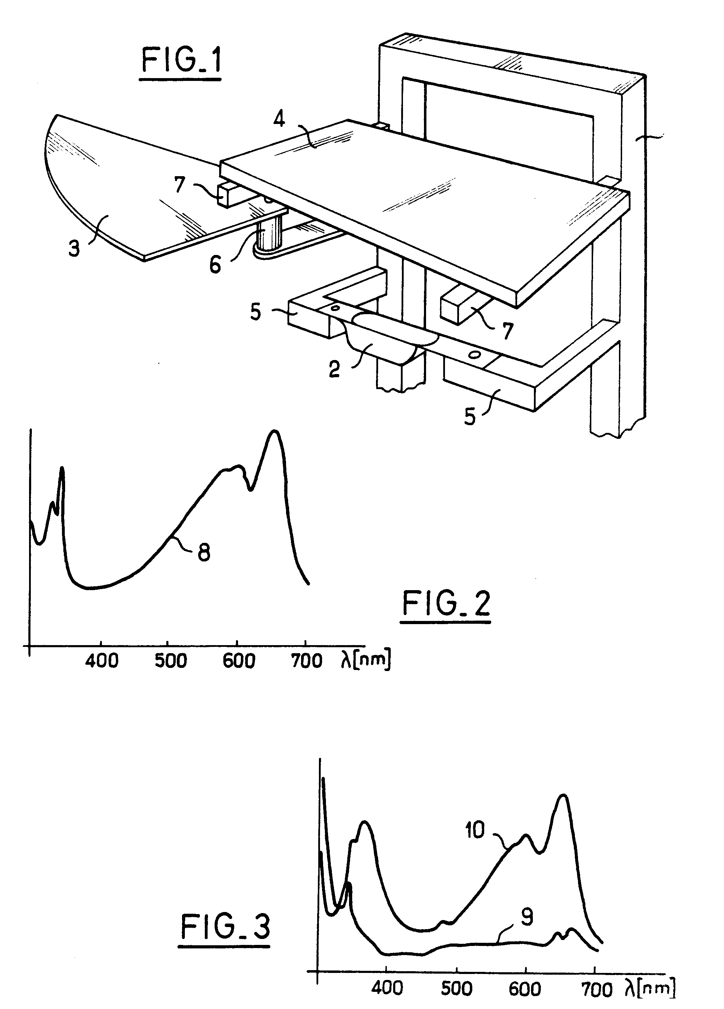

Le dispositif présenté figure 1 est destiné à être utilisé dans une installation sous vide. Il permet de mettre en oeuvre une technique dite de "dépôt par jet moléculaire" sur un monomère de polydiacétylène.

Les différents éléments du dispositif sont fixés à un portique 1, lié au bâti de vide. Ces éléments sont successivement, de bas en haut, un creuset 2, un obturateur tournant 3 et un substrat 4.

Le creuset est en tantale, il est porté mécaniquement par deux bras rigides faits d'une matière isolante. Le creuset est relié à deux amenées de courant non représentées qui permettent de le soumettre à une tension qu'on peut régler à volonté ce qui détermine une puissance induite et permet donc de porter le creuset à la température que l'on désire. Celle-ci est mesurée à l'aide d'une sonde à résistance de platine non représentée.

L'obturateur 3 qui a la forme d'un secteur de cercle est porté par l'axe d'un moteur 6 qui permet, par sa rotation de choisir l'instant où le dépôt peut s'effectuer sur le substrat et également, d'arrêter le dépôt, le moment venu.

Le substrat 4 repose sur un support 7 et sa face inférieure est exposée aux vapeurs issues du creuset 2. Il se trouve à environ 10 cm de celui-ci.

En plus des éléments représentés, on dispose d'une installation d'ultra-vide classique avec ses équipements habituels. On utilise également, pour suivre le déroulement des opérations, un quartz non représenté et qui est placé dans le plan inférieur du substrat. Ses variations de fréquence permettent de suivre, de manière classique, à chaque instant, la masse superficielle du dépôt.

Pour obtenir les produits de l'invention, on place sur les supports 7, la surface fraîchement clivée d'un monocristal de phtalate acide d'un métal alcalin, d'ammonium ou de thallium. Le clivage est effectué de la manière habituelle en provoquant un choc à l'aide d'une lame parallèlement à un plan (001).

Il est impératif que le clivage n'ait pas lieu trop longtemps avant l'introduction dans l'installation où le vide est immédiatement réalisé. Il est préférable que cette durée ne dépasse pas trois minutes. L'épaisseur du monocristal ne joue aucun rôle.

Un procédé selon l'invention pour obtenir le produit de l'invention consiste à opérer de la manière suivante :

On introduit dans le creuset 2 une quantité suffisante d'un monomère de polydiacétylène purifié cristallisé sous forme de fines aiguilles.

Il aura pu être préparé par la méthode décrite dans le brevet US 4 125 534. Ce sera par exemple du [1,6-di-(n-carbozolyl)-2,4-hexadiyne] qu'on appelera monoDCH dans la suite. La quantité choisie se définit empiriquement, elle dépend de l'épaisseur de la couche de polymère souhaitée et de la géométrie de l'installation.

Lorsque le vide atteint une valeur de l'ordre de 10⁻⁵Pa, soit dans le cas de l'installation de la figure 1, après une durée de 5 heures environ, on fait passer le courant électrique dans le creuset 2 alors que l'obturateur 3 est fermé. Dès que la température atteint 180°C, on ouvre l'obturateur et l'on mesure en continu la masse surfacique de la couche déposée sur le quartz - qui est voisine de celle déposée sur le substrat - lorsque l'épaisseur souhaitée est atteinte, on referme l'obturateur puis on coupe l'alimentation du creuset. On introduit de l'argon dans l'enceinte qui, après retour à la pression atmosphérique, est ouverte. Le monocristal recouvert de sa couche est alors porté dans une enceinte chauffée où la polymérisation s'effectue. La durée de celle-ci dépend de la température. Avec le DCH à 150°C, à l'air, elle dure au moins 3 heures et de préférence 24 heures. Si l'on désire réduire fortement les durées, il convient d'effectuer la polymérisation sous atmosphère neutre, d'azote par exemple. A 170°C on peut ainsi réduire à une heure la durée de la polymérisation.

La combinaison couche polycristalline épitaxiée de polydiacétylène sur phtalate acide alcalin de l'invention montre d'étonnantes propriétés optiques.

Celles-ci sont mises en évidence grâce aux résultats présentés sur les figures 2 et 3.

Sur la figure 2, on montre la densité optique 8 (unités arbitraires) en fonction de la longueur d'onde (en nanomètres) dans le cas d'une couche de polyDCH obtenue par une méthode semblable à celle qu'on vient de décrire mais sur un support en silice amorphe. L'épaisseur de la couche de monomère était de 100 nm. Une telle couche est polycristalline mais l'orientation des microcristaux est aléatoire, la densité optique à une longueur d'onde donnée ne dépend pas de l'état de polarisation de la lumière : on ne constate aucun pléochroïsme.

Au contraire, la couche de polyDCH de la figure 3, déposée cette fois-ci sur un monocristal d'orthophtalate acide de potassium (KAP) orthorhombique avec une épaisseur de monomère de 30 nm présente un pléochroïsme net : la courbe 9, qui représente la densité optique obtenue lorsque le plan de polymérisation de la lumière est parallèle à l'axe b du cristal est très différente de celle représentée courbe 10 et qui correspond à une lumière polarisée dont le plan de polarisation est perpendiculaire à ce même axe b.

Le pléochroïsme n'est qu'une manifestation, en optique linéaire, de l'anisotropie cristalline. Mais les couches selon l'invention permettent de réaliser aussi des systèmes dans le domaine de l'optique non-linéaire tels que par exemple des bistables optiques, des modulateurs tout optique ou des générateurs d'harmonique 3 pour les hautes densités d'énergie.

Les quatre exemples qui vont suivre permettront d'observer trois produits selon l'invention en comparaison avec un autre qui correspond aux techniques antérieures.

### Exemple 1

L'exemple 1 qui servira de référence présente une technique de dépôt sur un monocristal minéral qui permet d'obtenir une certaine épitaxie.

Le dispositif est celui de la figure 1. Le monocristal est du bromure de potassium cubique. Le clivage est effectué juste avant l'introduction du substrat dans l'enceinte. Son épaisseur est de 2 mm. On introduit dans le creuset un excès de poudre fine de DCH obtenu par couplage d'une molécule de [3-(9-carbazolyl)1-propyne]. Le précurseur de carbazolyl propyne est obtenu par la méthode classique au butyl-lithium. Les fines aiguilles cristallisées de DCH sont précipitées à partir d'une solution acétone-toluène. La formule du DCH est :

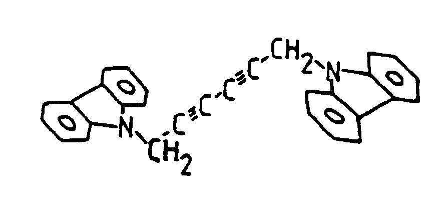

Son analyse pondérale donne C = 88,3 %, H = 4,9 % et N = 6,8 %.

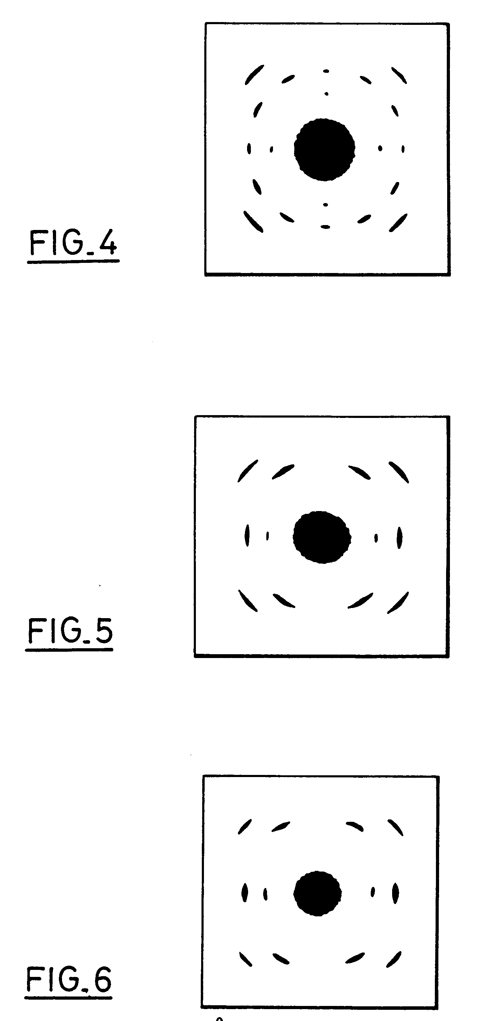

Après établissement de l'ultra vide, on fait passer le courant dans le creuset alors que l'obturateur est fermé. Lorsque la température atteint 180°C, on ouvre l'obturateur qui est refermé après 60 secondes. On constate qu'une épaisseur de 27 nm a été déposée. On arrête le chauffage dans le creuset, on introduit de l'argon dans l'enceinte avant de laisser entrer l'air ambiant. Le substrat monocristallin est alors porté dans une étuve où il est gardé pendant 24 heures à 150°C. Dans ces conditions, la polymérisation du DCH est complète. La couche de polyDCH recouverte de carbone est alors séparée du substrat en l'introduisant dans l'eau. On la recueille sur une grille de microscopie électronique. Le cliché de diffraction électronique obtenu est montré figure 4. Il permet de constater un bon parallélisme des microcristaux (dispersion ± 4°) mais également une bi-orientation de ceux-ci.

### Exemple 2

Le déroulement de l'expérience est en tout point identique au précédent sauf en ce qui concerne le substrat qui est un monocristal de KAP clivé selon un plan (001) juste avant son introduction dans l'enceinte, son épaisseur est de 0,27 mm. Le diagramme de diffraction électronique du polymère est celui de la figure 5. On constate une seule orientation (le nombre de taches de diffraction est moitié de ce qu'il était dans l'exemple 1) et une dispersion également faible de ± 8°.

### Exemple 3

Le substrat est ici un monocristal de KAP d'une épaisseur de 0,91 mm, il a une forme de triangle isocèle, de base 95 mm et de côtés 55 mm. La quantité de DCH placée dans le creuset est plus importante ici ce qui fournit des conditions différentes : on chauffe le creuset pour obtenir une vitesse de dépôt de 0,8 à 1 nm/sec, à la fin de l'opération, la température atteint 240°C. On obtient une couche d'épaisseur 145 nm qui, après polymérisation, apparaît bleutée en lumière naturelle et qui agit comme un polariseur.

### Exemple 4

Les conditions sont celles des exemples 1 et 2 mais le substrat est cette fois un monocristal d'orthophtalate acide de rubidium (RbAP). Il est clivé juste avant son introduction dans l'enceinte. Son épaisseur est alors 0,92 mm.

L'obturateur est ouvert lorsque la température du creuset atteint 180°C. On le referme après une minute. On constate que le monomère de DCH a alors une épaisseur de 32 nm.

Après polymérisation, on observe cette couche au microscope électronique, le diagramme de diffraction obtenu est présenté figure 6.

On constate ici aussi une mono-orientation et une dispersion de ± 8°.

## Revendications

1. Produit comportant une couche de polydiacétylène déposée par épitaxie sur un monocristal organique, caractérisé en ce que la couche de polydiacétylène est déposée sur un monocristal organique comprenant des groupements aromatiques.

2. Produit selon la revendication 1, caractérisé en ce que le monocristal est un orthophtalate.

3. Produit selon la revendication 2, caractérisé en ce que le monocristal est un monocristal d'orthophtalate acide d'un métal alcalin ou d'ammonium ou de thallium.

4. Produit selon l'une des revendications précédentes, caractérisé en ce que le polydiacétylène est le 1,6-di(n-carbazolyl)-2,4-hexadiyne.

5. Produit selon l'une des revendications précédentes, caractérisé en ce que le monocristal support est fraîchement clivé.

6. Produit selon la revendication 2 et la revendication 5, caractérisé en ce que le plan de clivage du monocristal est le plan (OO1).

7. Produit selon la revendication 4, caractérisé en ce que la couche de polydiacétylène est polycristalline.

8. Produit selon la revendication 7, caractérisé en ce que le fond est microcristallin et formé de cristaux de 0,1 à 0,3 µm et qu'il supporte des aiguilles parallèles de 2 à 6 µm de long.

9. Procédé d'élaboration d'un produit comportant une couche de polydiacétylène microcristalline orientée et comportant les étapes suivantes :
a. clivage d'un monocristal d'orthophtalate acide d'un métal alcalin, ou d'ammonium ou de thallium selon un plan (001).
b. dépôt sur la face obtenue, par évaporation thermique sous vide, d'un monomère diacétylénique.
c. polymérisation.

10. Procédé selon la revendication 9, caractérisé en ce que le monomère diacétylénique est le 1,6-di(n-carbazolyl)2,4-hexadiyne.

11. Procédé selon la revendication 10, caractérisé en ce que la température d'évaporation est comprise entre 150 et 240°C sous vide inférieur à 10⁻⁴Pa.

12. Procédé selon la revendication 10, caractérisé en ce que la polymérisation du monomère diacétylénique s'effectue en élevant la température jusqu'à une limite d'autant plus élevée que le temps est plus court.

13. Procédé selon la revendication 12, caractérisé en ce que la température de polymérisation est comprise entre 140 et 170°C.

14. Procédé selon la revendication 9, caractérisé en ce qu'on ne laisse pas à la surface du monocristal fraîchement clivée un temps suffisant pour qu'une dégradation à l'atmosphère ambiante se produise.

15. Procédé selon la revendication 14, caractérisé en ce que la mise sous vide s'effectue dans un délai inférieur à 3 mn après le clivage.

16. Application du produit selon l'une des revendications 1 à 8 la réalisation de dispositifs mettant en oeuvre l'optique non-linéaire.

## Patentansprüche

1. Produkt mit einer durch Epitaxie auf einem organischen Einkristall aufgebrachten Polydiacetylenschicht, dadurch gekennzeichnet, daß die Polydiacetylenschicht auf einem aromatische Gruppen enthaltenden organischen Einkristall aufgebrächt ist.

2. Produkt nach Anspruch 1, dadurch gekennzeichnet, daß der Einkristall ein Orthophthalat ist.

3. Produkt nach Anspruch 2, dadurch gekennzeichnet, daß der Einkristall der Einkristall eines sauren Orthophthalats eines Alkalimetalls, von Ammonium oder von Thallium ist.

4. Produkt nach einem der vorstehenden Ansprüche, dadurch gekennzeichnet, daß das Polydiacetylen 1,6-Di(N-carbazolyl)-2,4-hexadiin ist.

5. Produkt nach einem der vorstehenden Ansprüche, dadurch gekennzeichnet, daß der Träger-Einkristall frisch gespalten ist.

6. Produkt nach Anspruch 2 und Anspruch 5, dadurch gekennzeichnet, daß die Spaltungsebene des Einkristalls die Ebene (001) ist.

7. Produkt nach Anspruch 4, dadurch gekennzeichnet, daß die Polydiacetylenschicht polykristallin ist.

8. Produkt nach Anspruch 7, dadurch gekennzeichnet, daß der Untergrund mikrokristallin ist und aus Kristallen von 0,1 bis 0,3 µm gebildet ist, wobei er parallele Nadeln von 2 bis 6 µm Länge trägt.

9. Verfahren zur Herstellung eines Produkts mit einer orientierten mikrokristallinen Polydiacetylenschicht, das die folgenden Schritte aufweist:
a. Spalten eines einkristallinen sauren Orthophthalats eines Alkalimetalls oder von Ammonium oder von Thallium entlang der Ebene (001);
b. Aufbringen auf der erhaltenen Seite, eines Diacethylenmonomers durch thermische Vakuumverdampfung;
c. Polymerisation.

10. Verfahren nach Anspruch 9, dadurch gekennzeichnet, daß das Diacetylenmonomer 1,6-Di(N-carbazolyl)-2,4-hexadiin ist.

11. Verfahren nach Anspruch 10, dadurch gekennzeichnet, daß die Verdampfungstemperatur zwischen 150 und 245° C bei einem Vakkuum von weniger als 10⁻⁴Pa liegt.

12. Verfahren nach Anspruch 10, dadurch gekennzeichnet, daß die Polymerisation des Diacetylenmonomers durch Erhöhung der Temperatur bis zu einem Grenzwert erfolgt, der umso höher ist, je kürzer die Zeit ist.

13. Verfahren nach Anspruch 12, dadurch gekennzeichnet, daß die Polymerisationstemperatur zwischen 140 und 170° C liegt.

14. Verfahren nach Anspruch 9, dadurch gekennzeichnet, daß man die Oberfläche des frisch gespaltenen Einkristalls nicht über eine Zeit liegen läßt, daß eine Beschädigung in der Umgebungsatmosphäre stattfinden kann.

15. Verfahren nach Anspruch 14, dadurch gekennzeichnet, daß die Einbringung ins Vakuum in einer Zeit von weniger als 3 min nach der Spaltung erfolgt.

16. Verwendung des Produkts nach einem der Ansprüche 1 bis 8 bei der Herstellung von Vorrichtungen, die von nichtlinearer Optik Gebrauch machen.

## Claims

1. Product comprising a polydiacetylene film deposited by epitaxy on an organic monocrystal, characterized in that the polydiacetylene film is deposited on an organic monocrystal comprising aromatic groups.

2. Product according to Claim 1, characterized in that the monocrystal is an orthophthalate.

3. Product according to Claim 2, characterized in that the monocrystal is an acid orthophthalate monocrystal of an alkali metal or of ammonium or thallium.

4. Product according to one of the preceding Claims, characterized in that the polydiacetylene is 1,6-di(n-carbazolyl)-2,4-hexadiyne.

5. Product according to one of the preceding Claims, characterized in that the monocrystal support is newly cleaved.

6. Product according to Claim 2 and Claim 5, characterized in that the cleavage plane of the monocrystal is the (001) plane.

7. Product according to Claim 4, characterized in that the polydiacetylene film is polycrystalline.

8. Product according to Claim 7, characterized in that the base is microcrystalline and is formed of crystals of 0.1 to 0.3 µm and that it supports parallel needles of 2 to 6 µm length.

9. Process for the production of a product comprising an orientated microcrystalline polydiacetylene film and having the following steps:
a. cleavage of an acid orthophthalate monocrystal of an alkali metal or of ammonium or of thallium on a (001) plane,
b. deposition on the face obtained, by thermal evaporation under vacuum, of a diacetylenic monomer,
c. polymerization.

10. Process according to Claim 9, characterized in that the diacetylenic monomer is 1,6-di(n-carbazolyl)2,4-hexadiyne.

11. Process according to Claim 10, characterized in that the evaporation temperature is from 150 to 240°C under a vacuum less than 10⁻⁴Pa.

12. Process according to Claim 10, characterized in that the polymerization of the diacetylenic monomer takes place by raising the temperature to a limit, the limit being higher the shorter the time.

13. Process according to Claim 12, characterized in that the polymerization temperature is from 140 to 170°C.

14. Process according to Claim 9, characterized in that the surface of the newly cleaved monocrystal is not allowed sufficient time for a degradation in the ambient atmosphere to take place.

15. Process according to Claim 14, characterized in that the placing under vacuum takes place within a period of less than 3 minutes after cleavage.

16. Application of the product according to one of Claims 1 to 8 to the production of devices using non-linear optics.
